# FASCICULE DE BREVET EUROPEEN

(11) **EP 1 915 821 B1**
(45) Date de publication et mention de la délivrance du brevet: **18.03.2009**
(21) Numéro de dépôt: 06794420.7
(22) Date de dépôt: 12.05.2006
(51) Int. Cl.: H03K 3/57

(54) **DISPOSITIF DE COMMANDE D'UN TRANSISTOR HAUTE TENSION, EN PARTICULIER UN TRANSISTOR MOS D'UN GENERATEUR HAUTE TENSION RADIO-FREQUENCE POUR L'ALLUMAGE COMMANDE D'UN MOTEUR A COMBUSTION INTERNE**
VORRICHTUNG ZUR STEUERUNG EINES HOCHSPANNUNGSTRANSISTORS, INSBESONDERE EINES MOS-TRANSISTORS EINES HOCHSPANNUNGS-FUNKFREQUENZGENERATORS ZUR ZÜNDUNG EINES VERBRENNUNGSMOTORS
DEVICE FOR CONTROLLING A HIGH-VOLTAGE TRANSISTOR, IN PARTICULAR A MOS TRANSISTOR OF A HIGH-VOLTAGE RADIO-FREQUENCY GENERATOR FOR THE SPARK IGNITION OF AN INTERNAL COMBUSTION ENGINE

(30) Priorité: 06.07.2005 FR 0507211
(43) Date de publication de la demande: 30.04.2008
(73) Titulaire: RENAULT S.A.S., 92100 Boulogne Billancourt (FR)
(72) Inventeur: AGNERAY, ANDRE, F-92100 Boulogne (FR); NOUVEL, Clément, F-92140 Clamart (FR)
(86) Numéro de dépôt international: PCT/FR2006/050435
(87) Numéro de publication internationale: WO 2007/006984

(56) Documents cités:
- EP-A- 0 903 857
- FR-A- 2 859 831
- US-A- 5 113 839
- US-A- 5 634 453
- US-A- 5 789 951
- US-A1- 2002 093 372
- PATENT ABSTRACTS OF JAPAN vol. 007, no. 081 (M-205), 5 avril 1983 (1983-04-05) -& JP 58 008267 A (NISSAN JIDOSHA KK), 18 janvier 1983 (1983-01-18)

## Description

L'invention concerne la commande de transistors haute tension et notamment ceux présentant une capacité grille-drain importante et devant être commutés à des fréquences de plusieurs MHz comme c'est par exemple le cas pour les générateurs de haute tension alternative radio-fréquence (1Kv/20A/5MHz) pour l'allumage commandé d'un moteur à combustion interne. Un exemple d'un tel transistor peut être le transistor MOS (Metal Oxyde Semiconducteur).

Des exemples de réalisations de tels générateurs sont par exemple décrits dans les demandes de brevet français n° 2 859 869, 2 859 830 et 2 859 831 au nom de la demanderesse.

US 5 789 951 décrit un circuit de protection d'un transistor de puissance contre un claquage par avalanche. Le transistor de puissance commande la commutation d'une inductance. Le circuit de protection fait dissiper dans le transistor de puissance l'énergie stockée dans l'inductance. Un circuit de sélection commute le transistor de puissance dans un mode de conduction en réponse à une forte tension sur le collecteur du transistor de puissance empêchant ainsi un claquage du transistor par avalanche.

La réalisation d'un générateur de haute tension alternative radio-fréquence nécessite la commande rapide d'un transistor haute tension, ayant sa source à la masse.

Or, les dispositifs de commande (ou « drivers » selon une dénomination anglo-saxonne habituellement utilisée par l'homme du métier) utilisés actuellement pour commander de tels transistors MOS sous haute tension et pour des fréquences de commutation de plusieurs MHz présentent pour la plupart d'entre eux des délais de propagation entre l'entrée et la sortie trop importants pour le mode d'asservissement envisagé.

Compte tenu des performances requises, il existe dans l'état de la technique des solutions à transformateurs permettant d'appliquer sur la grille du transistor haute tension, une tension symétrique susceptible de bloquer le transistor efficacement. Ces solutions sont néanmoins généralement plus chères que des circuits à composants actifs non bobinés.

L'invention vise à apporter une solution à ce problème.

Un but de l'invention est de fournir un dispositif de commande rapide d'un transistor, en particulier un transistor haute tension pour un générateur haute tension alternative radio-fréquence, capable de respecter un temps de propagation des signaux entre l'entrée et la sortie de l'ordre de 15 à 20ns tout en offrant une architecture unipolaire à base de composants actifs non bobinés.

Selon un aspect de l'invention, il est par conséquent proposé un montage de type « push-pull » avec commande synchronisée de deux transistor MOS complémentaires de commande.

Plus précisément, selon cet aspect de l'invention, il est proposé un dispositif de commande d'un transistor haute tension, en particulier un transistor MOS d'un générateur à haute tension radio-fréquence comprenant :
- une borne d'entrée pour recevoir un signal logique de commande,
- une borne de sortie pour délivrer un signal de commande de sortie du transistor haute tension,
- un premier transistor de commande NMOS à faible impédance interne connecté entre la masse et la borne de sortie et dont la grille est reliée à ladite borne d'entrée,
- un deuxième transistor PMOS de commande connecté entre une borne d'alimentation et la borne de sortie et dont la grille est connectée à ladite borne d'entrée par l'intermédiaire d'un transistor bipolaire agencé en montage base commune et commandé en courant sur son émetteur par un circuit de liaison capacitif.

En raison de l'effet MILLER associé à la capacité grille-drain du transistor et pour des temps de commutation de l'ordre de 10ns, il apparaît sur la grille du transistor haute tension, lors de son blocage, des courants de l'ordre de la dizaine d'ampères. Il est donc nécessaire, pour éviter la remise en conduction et l'oscillation du transistor, de présenter un circuit de commande ayant une faible impédance vis-à-vis de la masse ce qui est réalisé ici par l'utilisation d'un transistor NMOS de commande ayant une impédance interne faible, typiquement inférieure à un Ohm, et de préférence sensiblement inférieure à 0,5 Ohm.

Par ailleurs, la commande du deuxième transistor PMOS de commande, effectuée par l'intermédiaire notamment d'un transistor bipolaire agencé en montage base commune et commandé en courant sur son émetteur par un circuit de liaison capacitif, permet d'assurer une commutation efficace et rapide même quand la tension d'alimentation est faible ce qui peut se produire au démarrage d'un véhicule lorsque la tension batterie peut chuter à moins de 8 V.

Selon un mode de réalisation, le circuit de liaison capacitif comprend un condensateur connecté à ladite borne d'entrée, une première résistance connectée à l'émetteur du transistor bipolaire et un moyen formant diode connecté en série entre la première résistance et le condensateur.

Le dispositif comprend en outre avantageusement une deuxième résistance connectée entre le collecteur du transistor bipolaire et la borne d'alimentation et formant avec le transistor bipolaire un étage translateur de niveau, ainsi qu'un étage suiveur connecté entre l'étage translateur de niveau et la grille du deuxième transistor PMOS de commande.

Il est préférable par ailleurs que le dispositif comprenne en outre un premier circuit amplificateur connecté entre la grille du premier transistor NMOS de commande et la borne d'entrée, et un deuxième circuit amplificateur connecté entre la borne d'entrée et le circuit de liaison capacitif.

Ces deux circuits amplificateurs, qui sont par exemple réalisés par un circuit logique MOS de la famille 74AC, permettent, lorsque cela est nécessaire, d'amplifier en courant le signal logique de commande (qui est par exemple un signal 0-5Volts) de façon à fournir un courant suffisant sur les grilles des transistors de commande au moment de leur commutation.

Même si le transistor PMOS de commande et le transistor NMOS de commande ne commutent théoriquement pas au même instant, puisque leur commutation respective est liée à l'état haut ou à l'état bas du signal logique de commande d'entrée, il se peut, compte tenu des temps de propagations à l'intérieur du circuit et de la fréquence de commutation que ces deux transistors de commande commutent néanmoins en même temps pendant un court instant. Bien que cela ne soit pas gênant pour le fonctionnement du dispositif, cela provoque une perte par dissipation. Pour remédier à cet inconvénient, il est prévu que le dispositif comprenne avantageusement un réseau de déphasage connecté entre la borne d'entrée et la grille du premier transistor NMOS de commande, par exemple connecté entre la borne d'entrée et l'entrée du premier circuit amplificateur, de façon à décaler les signaux de commande des deux transistors de commande.

Afin d'augmenter la plage de fréquence pour le fonctionnement du dispositif, et notamment pour permettre une utilisation efficace du dispositif de commande à basse fréquence, il est avantageusement prévu que le dispositif comprenne en outre un circuit amplificateur additionnel dont l'entrée est connectée à ladite borne d'entrée et un transistor NMOS additionnel connecté entre la masse et le connecteur du transistor bipolaire agencé en montage base commune, et dont la grille est connectée à la sortie du circuit amplificateur additionnel.

Le dispositif tel que défini ci avant s'applique en particulier à la commande d'un transistor d'un générateur haute tension radio-fréquence pour l'allumage commandé d'un moteur à combustion interne.

Une autre application possible est la commande d'un transistor d'un générateur haute tension radiofréquence pour la génération de plasma.

D'autres avantages et caractéristiques de l'invention apparaîtront à l'examen de la description détaillée de modes de réalisation, nullement limitatifs, et des dessins annexés sur lesquels :
- la figure 1 illustre un premier mode de réalisation d'un dispositif selon l'invention,
- la figure 2 illustre plus en détails une partie du dispositif de la figure 1,
- la figure 3 illustre un autre mode de réalisation d'un dispositif selon l'invention.

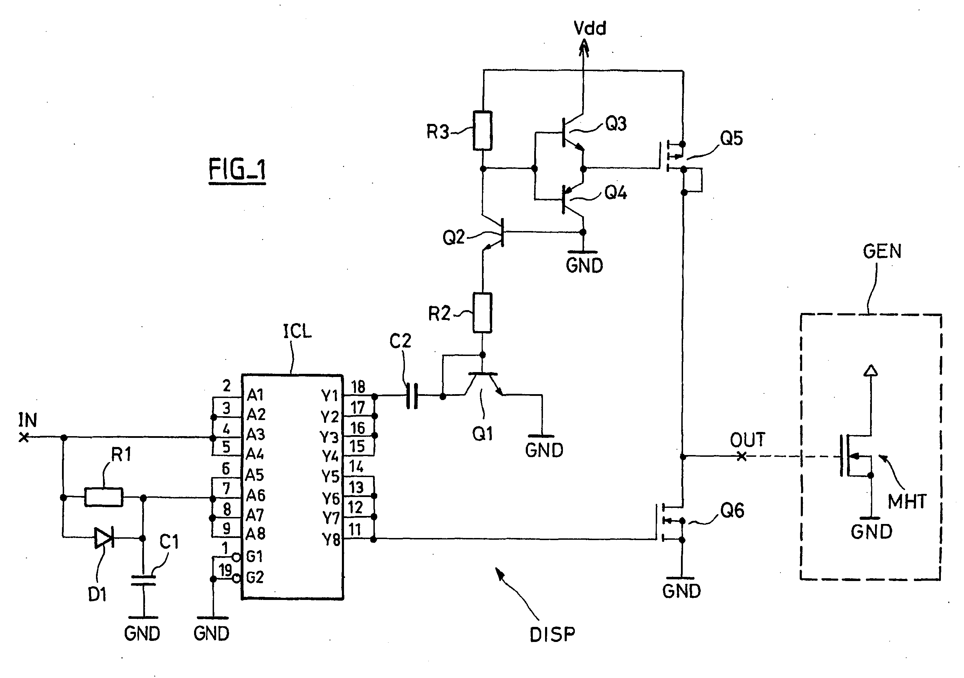

Sur la figure 1, la référence DISP désigne un dispositif de commande d'un transistor haute tension MHT, ayant sa source à la masse GND et appartenant par exemple à un générateur de haute tension alternative radio-fréquence utilisé pour l'allumage commandé de moteurs à combustion interne.

Le dispositif DISP comporte une borne d'entrée IN apte à recevoir un signal logique de commande pouvant prendre un état logique haut (par exemple 5V) ou un état logique bas (par exemple 0 V).

Le signal logique de commande attaque les entrées 2, 3, 4 et 5 d'un circuit logique MOS de la famille 74AC référencé ICI, par exemple le circuit 74AC 541 commercialisé par la société Fairchild par exemple.

Le signal logique de commande attaque également, par l'intermédiaire d'un réseau de déphasage formé de la résistance R1, de la diode D1 et du condensateur C1, et dont on reviendra plus en détails sur la fonctionnalité ci-après, quatre autres entrées du circuit ICI, à savoir les entrées 6, 7, 8 et 9.

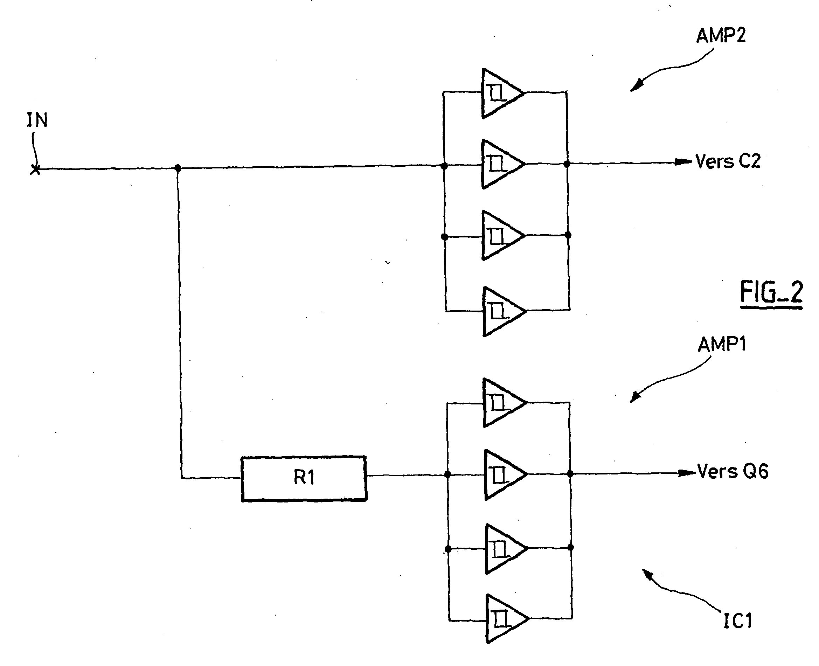

Comme illustré plus particulièrement sur la figure 2, les entrées 6, 7, 8 et 9 sont reliées à quatre portes du type de la famille AC14 montées en parallèle et formant un premier circuit amplificateur AMP1.

De même, les entrées 2, 3, 4 et 5 sont reliées à quatre autres portes AC14, également montées en parallèle, et formant un deuxième circuit amplificateur AMP2.

Chacune de ces portes logiques est capable de délivrer en sortie un courant de 50 mA ce qui permet d'obtenir en sortie de chaque circuit amplificateur AMP22 un courant de 200 mA permettant une bonne commande des transistors de commande que l'on va détailler ci-après.

La sortie du premier circuit amplificateur AMP1 est directement relié à la grille d'un premier transistor de commande Q6, qui est un transistor NMOS.

Ce premier transistor de commande Q6 a une impédance interne relativement à la masse extrêmement faible. A titre indicatif, on choisira par exemple le transistor portant la référence PHP3055 commercialisé par la société Philips et qui présente une impédance interne de l'ordre de 0,1 Ohm.

Alors que la source du transistor Q6 est reliée à la masse, son drain est relié à la borne de sortie OUT du dispositif de commande DISP.

La sortie du deuxième circuit amplificateur AMP2 est reliée à un circuit de liaison capacitif, symétriseur de signal, formé d'un condensateur C2, d'un transistor Q1 monté en diode rapide, et d'une résistance R2, ces trois composants étant montés en série à la sortie du deuxième circuit amplificateur AMP2.

Ce circuit de liaison capacitif permet de commander en courant sur son émetteur un transistor bipolaire Q2 agencé selon un montage base commune, c'est-à-dire que sa base est reliée à la masse.

Le collecteur du transistor Q2 est relié par l'intermédiaire d'une résistance R3 à la tension d'alimentation VDD, qui est par exemple la tension batterie. Le transistor Q2 et la résistance R3 forment ainsi un étage translateur de niveau.

Le collecteur du transistor Q2 est connecté à la grille d'un deuxième transistor de commande Q5 qui est un transistor PMOS, par l'intermédiaire d'un étage suiveur classiquement constitué de deux transistors Q3 et Q4.

Le transistor PMOS Q5 est connecté entre la tension d'alimentation VDD et la borne de sortie OUT.

Le transistor Q5, qui a une tension de seuil de l'ordre de 5V et qui est aisément commandable sous une tension de 10V, est par exemple le transistor portant la référence IRFD9110 commercialisé par la société International Rectifier.

Le transistor Q2 commandé sur son émetteur en courant et ayant sa grille reliée à la masse permet d'obtenir une rapidité de commutation importante.

Par ailleurs, pour maintenir les possibilités de commutation rapide même quand la tension d'alimentation est faible (au démarrage d'un véhicule, la tension batterie peut chuter à moins de 8V) on utilise avantageusement le montage base commune c'est-à-dire qu'on relie la base de Q2 à la masse. Il faut en conséquence une tension négative sur son émetteur pour assurer sa commutation, ce qui est réalisé par le circuit de liaison capacitif C2/Q1/R2.

Ainsi, pendant une alternance positive sur la borne d'entrée, c'est-à-dire lorsque le signal logique de commande d'entrée passe à l'état haut, le condensateur C2 se charge à travers le transistor Q1 qui est utilisé en diode rapide jusqu'à une tension de l'ordre de la différence entre la tension d'alimentation du circuit logique MOS IC1 et la tension de seuil de la diode.

Lorsque le signal d'entrée passe à l'état logique bas, la sortie du circuit ICI passe également à une tension presque nulle et la tension aux bornes du condensateur C2 permet d'imposer un potentiel négatif sur la résistance R2 et donc de faire commuter le transistor Q2 de façon très violente. Le transistor de commande PMOS Q5 devient alors passant quelques nano secondes après.

Par contre, lorsque le signal logique d'entrée est à l'état haut, le transistor Q5 se bloque et le transistor Q6 conduit.

Cela étant, pour s'assurer que les deux transistors de commande Q5 et Q6 ne commutent pas en même temps, on utilise avantageusement le réseau de déphasage formé de la résistance R1 en parallèle avec la diode D1, et du condensateur C1 qui permet de décaler temporellement le signal logique de commande délivré en entrée du premier circuit amplificateur AMP1, de celui délivré en entrée du deuxième circuit amplificateur AMP2, ces deux circuits AMP1 et AMP2 étant réalisés dans le circuit logique MOS IC1.

Lorsque le transistor Q6 conduit, le transistor MOS haute tension MHT se bloque. Il apparaît alors une forte impulsion de courant sur la grille du transistor MHT. Mais, en raison de la faible impédance interne du transistor Q6, cette forte impulsion de courant ne se traduit pas par une tension sur la grille du transistor MHT suffisamment élevée pour permettre sa remise en conduction, ce qui conduirait alors à une oscillation indésirable du transistor MHT.

En d'autres termes, la faible impédance interne du transistor de commande Q6 permet d'assurer effectivement un blocage correct du transistor haute tension MHT.

Le dispositif de la figure 1 présente un temps de propagation entre l'entrée IN et la sortie OUT de l'ordre de 20ns avec un temps de montée de l'ordre de 15ns.

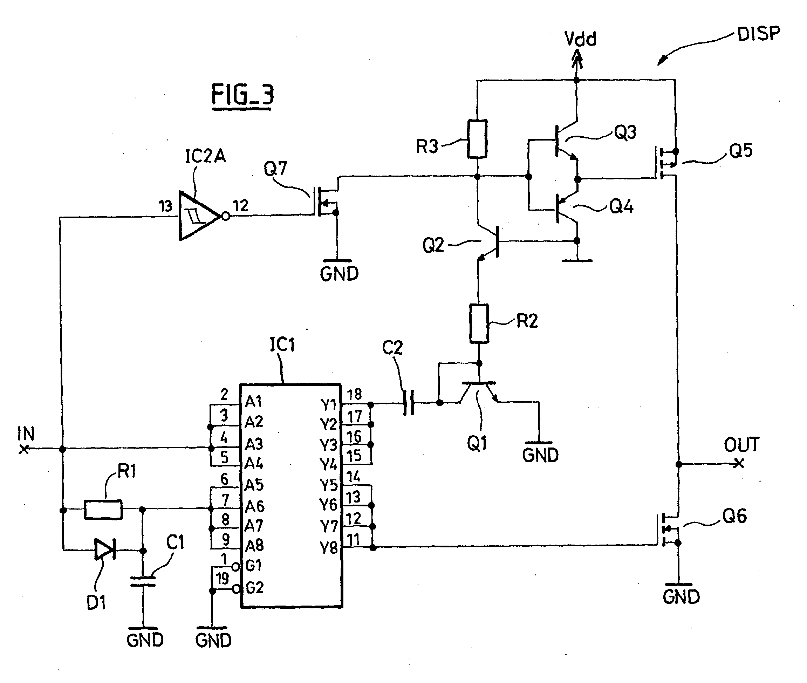

Le mode de réalisation du dispositif de la figure 1 est particulièrement adapté pour un fonctionnement à haute fréquence. Cela étant, pour augmenter la bande passante du dispositif, c'est-à-dire pour qu'il fonctionne efficacement dans une plage de fréquences plus large et notamment à basse fréquence, il est particulièrement avantageux d'utiliser le mode de réalisation de la figure 3.

Par rapport au mode de réalisation de la figure 1, le dispositif DISP illustré sur la figure 3 comprend en outre un circuit amplificateur additionnel IC2A, formé par exemple d'une porte 74AC140, connecté à la borne d'entrée IN, ainsi qu'un transistor NMOS additionnel Q7 connecté entre la masse et le collecteur du transistor Q2. La grille de ce transistor additionnel Q7 est connectée à la sortie du circuit amplificateur additionnel IC2A.

Le comportement dynamique lié aux valeurs du condensateur C2 (par exemple 100 nanofarad), de la résistance R2 (par exemple 50 Ohm) et de la résistance R3 (par exemple 120 Ohm) peut ne pas donner satisfaction à basse fréquence, car sur un front descendant du signal logique d'entrée, le condensateur C2 se charge à travers la résistance R2 et à travers la résistance R3 et finit par être complètement chargé si bien que le transistor Q2 peut se bloquer à nouveau et faire alors basculer la sortie à un instant non souhaité.

Aussi, pour permettre une utilisation acceptable du dispositif de commande à basse fréquence, malgré ce comportement dynamique qui est particulièrement adapté pour la réactivité à haute fréquence, on insère le circuit amplificateur additionnel IC2A et le transistor NMOS additionnel Q7.

Ainsi, sur une alternance négative du signal logique de commande d'entrée, le circuit formé du condensateur C2, du transistor Q1, de la résistance R2, du transistor Q2 et de la résistance R3 permet l'établissement d'un front rapide sur la sortie. De ce fait, le circuit additionnel IC2A/Q7 maintient un état bas en entrée de l'étage suiveur Q3/Q4 jusqu'à l'alternance suivante du signal logique d'entrée.

## Revendications

1. Dispositif de commande d'un transistor haute tension, **caractérisé par le fait qu'**il comprend une borne d'entrée (IN) pour recevoir un signal logique de commande, une borne de sortie (OUT) pour délivrer un signal de commande de sortie au transistor haute tension (MHT), un premier transistor de commande NMOS (Q6) connecté entre la masse et la borne de sortie (OUT) et dont la grille est reliée à ladite borne d'entrée, l'impédance interne du premier transistor de commande (Q6) étant faible vis-à-vis de la masse de façon à éviter une remise en conduction du transistor haute tension (MHT) lorsque le premier transistor de commande (Q6) conduit, un deuxième transistor PMOS de commande (Q5) connecté entre une borne d'alimentation (VDD) et la borne de sortie et dont la grille est connectée à ladite borne d'entrée par l'intermédiaire d'un transistor bipolaire (Q2) agencé en montage base commune et commande en courant sur son émetteur par un circuit de liaison capacitif (C2, Q1, R2).

2. Dispositif selon la revendication 1, dans lequel l'impédance interne du premier transistor NMOS de commande (Q6) est inférieure à un Ohm, de préférence inférieure à 0,5 Ohm.

3. Dispositif selon l'une des revendications précédentes, dans lequel le circuit de liaison capacitif comprend un condensateur (C2) connecté à ladite borne d'entrée, une première résistance (R2) connectée à l'émetteur du transistor bipolaire, et un moyen formant diode (Q1) connecté en série entre la résistance et le condensateur.

4. Dispositif selon l'une des revendications précédentes, comprenant en outre une deuxième résistance (R3) connectée entre le collecteur du transistor bipolaire (Q2) et la borne d'alimentation et formant avec le transistor bipolaire un étage translateur de niveau, ainsi qu'un étage suiveur (Q3, Q4) connecté entre l'étage translateur de niveau et la grille du deuxième transistor PMOS de commande.

5. Dispositif selon l'une des revendications précédentes, comprenant en outre un premier circuit amplificateur (AMP1) connecté entre la grille du premier transistor NMOS de commande et la borne d'entrée, et un deuxième circuit amplificateur (AMP2) connecté entre la borne d'entrée et le circuit de liaison capacitif.

6. Dispositif selon l'une des revendications précédentes, comprenant en outre un réseau de déphasage (R1, C1, D1) connecté entre la borne d'entrée et la grille du premier transistor NMOS de commande.

7. Dispositif selon l'une des revendications précédentes, comprenant en outre un circuit amplificateur additionnel (IC2A) dont l'entrée est connectée à ladite borne d'entrée et un transistor NMOS additionnel (Q7) connecté entre la masse et le collecteur dudit transistor bipolaire agencé en montage base commune, et dont la grille est connectée à la sortie du circuit amplificateur additionnel.

8. Application du dispositif selon l'une des revendications 1 à 7, à la commande d'un transistor d'un générateur haute tension radio-fréquence pour l'allumage commandé d'un moteur à combustion interne.

9. Application du dispositif selon l'une des revendications 1 à 7, à la commande d'un transistor d'un générateur haute tension radiofréquence pour la génération de plasma.

10. Application du dispositif selon l'une des revendications 1 à 7, à la commande d'un transistor MOS d'un générateur haute tension radiofréquence.

## Claims

1. Driver for driving a high-voltage transistor, **characterized in that** it comprises: an input terminal (IN) for receiving a logic drive signal; an output terminal (OUT) for delivering an output drive signal to the high-voltage transistor (MHT); an nMOS first drive transistor (Q6) which is connected between ground and the output terminal (OUT) and the gate of which is connected to said input terminal, the internal impedance of the first drive transistor (Q6) being low with respect to ground so as to prevent the high-voltage transistor (MHT) from being turned back on when the first drive transistor (Q6) is conducting; and a pMOS second drive transistor (Q5) which is connected between a supply terminal (VDD) and the output terminal and the gate of which is connected to said input terminal via a bipolar transistor (Q2) placed in a common base arrangement and current-controlled on its emitter by a capacitive coupling circuit (C2, Q1, R2).

2. Driver according to Claim 1, in which the internal impedance of the nMOS first drive transistor (Q6) is less than 1 ohm, preferably less than 0.5 ohms.

3. Driver according to either of the preceding claims, in which the capacitive coupling circuit comprises a capacitor (C2) connected to said input terminal, a first resistor (R2) connected to the emitter of the bipolar transistor, and a diode-forming means (Q1) connected in series between the resistor and the capacitor.

4. Driver according to one of the preceding claims, which further includes a second resistor (R3) connected between the collector of the bipolar transistor (Q2) and the supply terminal and forming, with the bipolar transistor, a level translator stage and also a follower stage (Q3, Q4) connected between the level translator stage and the gate of the pMOS second drive transistor.

5. Driver according to one of the preceding claims, which further includes a first amplifying circuit (AMP1) connected between the gate of the nMOS first drive transistor and the input terminal, and a second amplifying circuit (AMP2) connected between the input terminal and the capacitive coupling circuit.

6. Driver according to one of the preceding claims, which further includes a phase shift circuit (R1, C1, D1) connected between the input terminal and the gate of the nMOS first drive transistor.

7. Driver according to one of the preceding claims, which further includes an additional amplifying circuit (IC2A), the input of which is connected to said input terminal, and an additional nMOS transistor (Q7) connected between ground and the collector of said bipolar transistor placed in a common base arrangement, the gate of which transistor is connected to the output of the additional amplifying circuit.

8. Application of the driver according to one of Claims 1 to 7 for driving a transistor of a high-voltage radiofrequency generator for the spark ignition of an internal combustion engine.

9. Application of the driver according to one of Claims 1 to 7 for driving a transistor of a high-voltage radiofrequency generator for plasma generation.

10. Application of the driver according to one of Claims 1 to 7 for driving an MOS transistor of a high-voltage radiofrequency generator.

## Patentansprüche

1. Vorrichtung zur Steuerung eines Hochspannungstransistors, **dadurch gekennzeichnet, dass** sie eine Eingangsklemme (IN) zum Empfang eines logischen Steuersignals, eine Ausgangsklemme (OUT) zum Liefern eines Ausgangssteuersignals an den Hochspannungstransistor (MHT), einen ersten NMOS-Steuertransistor (Q6), der zwischen der Masse und der Ausgangsklemme (OUT) angeschlossen ist und dessen Gate mit der Eingangsklemme verbunden ist, wobei die interne Impedanz des ersten Steuertransistors (Q6) gegenüber der Masse niederohmig ist, um eine erneute Leitendmachung des Hochspannungstransistors (MHT) zu vermeiden, wenn der erste Steuertransistor (Q6) leitend ist, einen zweiten PMOS-Steuertransistor (Q5), der zwischen einer Versorgungsklemme (VDD) und der Ausgangsklemme angeschlossen ist und dessen Gate an die Eingangsklemme über einen bipolaren Transistor (Q2) angeschlossen ist, der in Basisschaltung eingerichtet und an seinem Emitter durch eine kapazitive Verbindungsschaltung (C2, Q1, R2) stromgesteuert ist.

2. Vorrichtung nach Anspruch 1, bei der die interne Impedanz des ersten NMOS-Steuertransistors (Q6) unter einem Ohm liegt, vorzugsweise unter 0,5 Ohm.

3. Vorrichtung nach einem der vorhergehenden Ansprüche, bei der die kapazitive Verbindungsschaltung einen Kondensator (C2), der an die Eingangsklemme angeschlossen ist, einen ersten Widerstand (R2), der an den Emitter des bipolaren Transistors angeschlossen ist, und eine ein Diode bildende Einrichtung (Q1) aufweist, die in Reihe zwischen den Widerstand und den Kondensator geschaltet ist.

4. Vorrichtung nach einem der vorhergehenden Ansprüche, die außerdem einen zweiten Widerstand (R3), der zwischen dem Kollektor des bipolaren Transistors (Q2) und der Versorgungsklemme angeschlossen ist und mit dem bipolaren Transistor eine Pegelumsetzerstufe bildet, sowie eine Folgestufe (Q3, Q4) aufweist, die zwischen der Pegelumsetzerstufe und dem Gate des zweiten PMOS-Steuertransistors angeschlossen ist.

5. Vorrichtung nach einem der vorhergehenden Ansprüche, die außerdem eine erste Verstärkerschaltung (AMP1), die zwischen dem Gate des ersten NMOS-Steuertransistors und der Eingangsklemme angeschlossen ist, und eine zweite Verstärkerschaltung (AMP2) aufweist, die zwischen der Eingangsklemme und der kapazitiven Verbindungsschaltung angeschlossen ist.

6. Vorrichtung nach einem der vorhergehenden Ansprüche, die außerdem ein Phasenverschiebungsnetzwerk (R1, C1, D1) aufweist, das zwischen der Eingangsklemme und dem Gate des ersten NMOS-Steuertransistors angeschlossen ist.

7. Vorrichtung nach einem der vorhergehenden Ansprüche, die außerdem eine zusätzliche Verstärkerschaltung (IC2A), deren Eingang an die Eingangsklemme angeschlossen ist, und einen zusätzlichen NMOS-Transistor (Q7) aufweist, der zwischen der Masse und dem Kollektor des bipolaren Transistors angeschlossen ist, der in Basisschaltung eingerichtet ist und dessen Gate an den Ausgang der zusätzlichen Verstärkerschaltung angeschlossen ist.

8. Anwendung der Vorrichtung nach einem der Ansprüche 1 bis 7 an die Steuerung eines Hochfrequenz-Hochspannungsgenerators zum gesteuerten Zünden eines Verbrennungsmotors.

9. Anwendung der Vorrichtung nach einem der Ansprüche 1 bis 7 an die Steuerung eines Hochfrequenz-Hochspannungsgenerators für die Erzeugung von Plasma.

10. Anwendung der Vorrichtung nach einem der Ansprüche 1 bis 7 an die Steuerung eines MOS-Transistors eines Hochfrequenz-Hochspannungsgenerators.
